# EUROPEAN PATENT APPLICATION

(11) **EP 4 760 326 A1**
(43) Date of publication of application: **17.06.2026**
(21) Application number: 24219876.0
(22) Date of filing: 13.12.2024
(51) Int. Cl.: G01R 33/421

(54) **COMPENSATION OF RAW FRINGE MAGNETIC FIELDS FOR MAGNETIC RESONANCE IMAGING**

(71) Applicant: Koninklijke Philips N.V., 5656 AE Eindhoven (NL)
(72) Inventor: VAN DEN BRINK, Johan Samuel, Eindhoven (NL)
(74) Representative: Philips Intellectual Property & Standards

(57) **Abstract**

In a magnetic resonance imaging (MRI) room, a raw fringe magnetic field compensating structure includes an active compensating coil adapted to reduce the target magnetic flux density outside a magnet apparatus of an MR in a defined area. The active compensating coils are not disposed in or on the magnet apparatus. A method of compensating a raw fringe magnetic field is also disclosed.

## Description

### BACKGROUND

Magnetic Resonance Imaging (MRI) devices comprise superconducting magnets used to generate the DC magnetic fields needed for MR imaging. Typical MR magnets comprise main coils and shield coils, with the main coils adapted to generate the main magnetic field and the shield coils adapted to shield the MRI device from stray fields often generated by gradient coils of the MRI device.

While MRI devices are ubiquitous, they nonetheless require a significant amount of space. Moreover, the constant magnetic field in regions near the MR magnet are also significant, and the function of certain electronic equipment in proximity to the MR magnet can be deleteriously impact. As such, in many known MR systems the spacing of such sensitive equipment required from the MR device requires a greater amount of real estate, which can be scarce in many healthcare setting. Moreover, the use of mobile MRI systems is likely to increase significantly in view of cost of real-estate, emerging screening solutions (breast, prostate) and point of care needs (cardiology, geriatrics). The size of these mobile MRI systems, of course, is also beneficially comparatively small, and thereby also present disadvantages to the use of sensitive electronic equipment therein.

What is needed, therefore, is an MRI system that overcomes at least the noted drawbacks of the known approaches described above.

### SUMMARY

In accordance with a representative embodiment, in a magnetic resonance imaging (MRI) room, a raw fringe magnetic field compensating structure, comprises: an active compensating coil adapted to reduce a target magnetic flux density outside a magnet apparatus of an MR in a defined area, wherein the active compensating coils are not disposed in or on the magnet apparatus.

In accordance with another representative embodiment, a method of compensating for a raw fringe magnetic field in an MRI room comprises: providing an active compensating coil adapted to reduce a target magnetic flux density outside a magnet apparatus of an MR in a defined area, wherein the active compensating coils are not disposed in or on the magnet apparatus.

### BRIEF DESCRIPTION OF THE DRAWINGS

The example embodiments are best understood from the following detailed description when read with the accompanying drawing Figures. It is emphasized that the various features are not necessarily drawn to scale. In fact, the dimensions may be arbitrarily increased or decreased for clarity of discussion. Wherever applicable and practical, like reference numerals refer to like elements.
Fig. 1 is a perspective view of a magnetic resonance imaging (MRI) system in accordance with a representative embodiment.
Fig. 2A is top view of a superconducting apparatus and lines of equal magnetic flux density of a raw fringe magnetic field before compensation in accordance with a representative embodiment.
Fig. 2B is side view of the superconducting apparatus of Fig. 3A showing lines of equal magnetic flux density of a target field before compensation in accordance with a representative embodiment.
Fig. 3 is a flow-chart of a method of determining a shape of a compensation coil and required current density in the compensation coil to provide a specified target shield in a region outside of a main superconducting magnet of an MRI system according to a representative embodiment.
Fig. 4A is top view of a superconducting apparatus and lines of equal magnetic flux density of a raw fringe magnetic field before compensation in accordance with a representative embodiment.
Fig. 4B is top view of a superconducting apparatus and lines of equal magnetic flux density of a compensated fringe field using a raw fringe magnetic field compensating structure comprising an active compensating coil in accordance with a representative embodiment.
Fig. 4C is top view of a superconducting apparatus and lines of equal magnetic flux density of a target compensation field after compensation using a raw fringe magnetic field compensating structure comprising an active compensating coil in accordance with a representative embodiment.

### DETAILED DESCRIPTION

In the following detailed description, for the purposes of explanation and not limitation, representative embodiments disclosing specific details are set forth in order to provide a thorough understanding of embodiments according to the present teachings. However, other embodiments consistent with the present disclosure that depart from specific details disclosed herein remain within the scope of the appended claims. Descriptions of known systems, devices, materials, methods of operation and methods of manufacture may be omitted so as to avoid obscuring the description of the representative embodiments. Nonetheless, systems, devices, materials and methods that are within the purview of one of ordinary skill in the art are within the scope of the present teachings and may be used in accordance with the representative embodiments. It is to be understood that the terminology used herein is for purposes of describing particular embodiments only and is not intended to be limiting. Definitions and explanations for terms herein are in addition to the technical and scientific meanings of the terms as commonly understood and accepted in the technical field of the present teachings.

It will be understood that, although the terms first, second, third etc. may be used herein to describe various elements or components, these elements or components should not be limited by these terms. These terms are only used to distinguish one element or component from another element or component. Thus, a first element or component discussed below could be termed a second element or component without departing from the teachings of the inventive concept.

As used in the specification and appended claims, the singular forms of terms 'a', 'an' and 'the' are intended to include both singular and plural forms, unless the context clearly dictates otherwise. Additionally, the terms "comprises," and/or "comprising," and/or similar terms when used in this specification, specify the presence of stated features, elements, and/or components, but do not preclude the presence or addition of one or more other features, elements, components, and/or groups thereof. As used herein, the term "and/or" includes any and all combinations of one or more of the associated listed items.

Unless otherwise noted, when an element or component is said to be "connected to", "coupled to", or "adjacent to" another element or component, it will be understood that the element or component can be directly connected or coupled to the other element or component, or intervening elements or components may be present. That is, these and similar terms encompass cases where one or more intermediate elements or components may be employed to connect two elements or components. However, when an element or component is said to be "directly connected" or "immediately adjacent" to another element or component, this encompasses only cases where the two elements or components are connected or disposed immediately adjacent to each other without any intermediate or intervening elements or components.

Unless otherwise noted, as used herein, when something is said to have approximately a certain value or being substantially a certain value, then it means that it is within 10% of that value.

As described herein in connection with various representative embodiments, the present teachings relate to a raw fringe magnetic field compensating structure and method of use comprising an active compensating coil, where the compensating magnetic field results from current provided by a power source to the active compensating coil. While all representative embodiments of the raw fringe magnetic field compensating structure described herein comprise an active compensating coil, the raw fringe magnetic field compensating structure may also comprise passive magnetic compensating elements (e.g. shim blocks) comprising rare earth metals. The inclusion of such passive magnetic compensating elements may beneficially reduce the overall cost and size of the magnetic field compensating structure of various representative embodiments.

The magnetic field that is compensated is substantially a static magnetic field generated by a superconducting magnet apparatus (sometimes referred to herein as magnet structure) or other magnet apparatuses (e.g., iron yoke structure), and existing not inside the superconducting magnet apparatus, but in the ambient region surrounding the superconducting magnet apparatus (e.g., an MRI room at a clinical setting or mobile MRI apparatus). Notably, the substantially static magnetic field that exist outside of the magnet apparatus may be referred to herein as a raw fringe magnetic field. As explained more fully below, the active compensating coil is placed external to the magnet assembly and adapted to "draw in" the lines of constant magnetic flux density to realize a desired target magnetic field, wherein a distance from the superconductive magnet apparatus to at least one of the lines of constant magnetic flux density is reduced. Thereby, less of the area ("real estate") of the ambient region is located within regions of comparatively high magnetic flux density, and/or in portions of the ambient regions, the magnitude of the magnetic flux density can be reduced. Beneficially, and among other benefits of the active compensating coil, the required area in which a superconducting magnet apparatus is disposed can be reduced, and/or an area of the ambient region surrounding the superconducting magnet apparatus having comparatively low magnetic flux density to provide a safer environment and to enable use of electronic equipment susceptible to electromagnetic interference by the static magnetic field of the superconducting magnet apparatus can be created. Additionally, the required space and mass for such field-extent reducing assemblies can be reduced relative to ferromagnetic shields. Stated somewhat differently, the active compensating coil of the present teachings enables the creation of regions in the ambient region surrounding the superconducting magnet apparatus having an acceptably low magnetic field density to enable electronic equipment susceptible to electromagnetic interference by the static magnetic field to function, and/or the total area of the ambient region in which the superconducting magnet apparatus is disposed to be reduced compared to known MRI systems. Furthermore, reduction of the magnetic flux density and/or creation of regions with comparatively low magnetic flux density can improve the safety of the use of the MRI system, such as by allowing metal objects to be located in the MRI room 120, and even closer to the superconducting magnet apparatus.

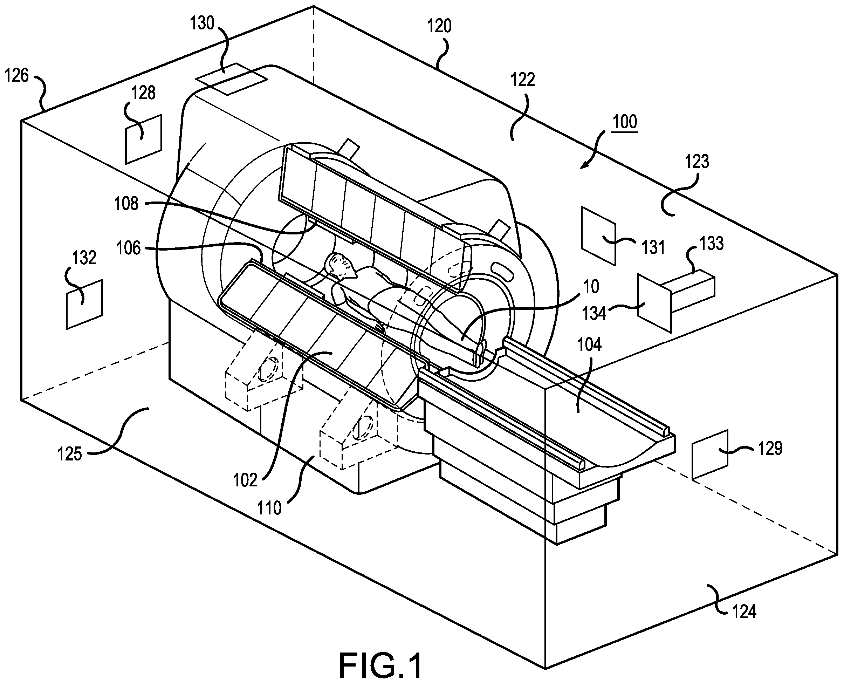

Fig. 1 is a perspective view of a magnetic resonance imaging (MRI) device 100 disposed in an MRI room 120 in accordance with a representative embodiment. The MRI device 100 comprises a magnet (e.g., superconducting magnet apparatus 102; a patient table 104 configured to hold a patient 10; electrically superconducting coils 106 configured to at least partially surround at least a portion of patient 10 for which MRI device 100 generates an image; a radio frequency coil 108 configured to apply a radio frequency signal to at least the portion of patient 10 which is being imaged, and to alter the alignment of the magnetic field. The general operation of an MRI device is known and many aspects of the MRI device are not repeated herein.

Notably, the superconducting magnet apparatus 102 may be one embodiment in the MRI device 100. It should be understood that, in general, superconducting magnet apparatus 102 may include many other components which are not illustrated in Fig. 1. Some components have been omitted from Fig. 1 for clarity of illustration, and so as not to obscure aspects of the present invention to be discussed below.

For example, a superconducting magnet apparatus 102 may include a cryostat (not shown) having an enclosure, or outer vacuum container (not shown) and a thermal shield (not shown) disposed within outer vacuum container and a helium tank (not shown). In certain representative embodiments, the superconducting magnet apparatus 102 is a helium bath type system. It is emphasized the use of a superconducting magnet apparatus 102 is merely illustrative, and other systems are contemplated. In some embodiments, a helium tank (not shown) may contain a relatively small amount of cryogenic fluid compared to helium volumes in typical helium bath type systems, for example 50 to 100 liters (or less) of liquid helium. For example, the cooling of the superconducting magnet coils may be carried out using BlueSeal^{™} structures commercially available from Koninklijke Philips, N.V. As is known, BlueSeal structures are an alternative to bath cooling in which cooling may be done using conduction and convective cooling using heat pipes or thermosiphons. Here, a cooling medium like helium is used to transport heat and supply some thermal mass. The cooling material is typically enclosed and guided in tubular structures (not shown), from the refrigerator to the regions that need to be cooled. Gravity and appropriate layout enable circulation of the refrigerant.

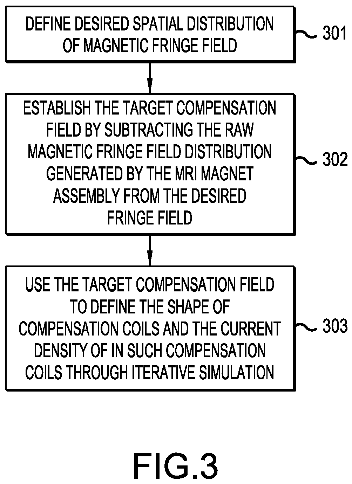

It is emphasized that the active compensating coil of the present teachings described herein are accessories to the MRI device 100, and beneficially are not disposed in or affixed to the superconducting magnet apparatus 102 (e.g., in the cryostat). It is advantageous, as described more fully below, when the active compensating coil is disposed in or affixed to the MRI room 120, such as on its ceiling 122, and/or one or more of its walls 123, 124, 125 and 126. Moreover, the active compensating coil may be disposed between the walls/ceiling of the MRI room 120 and the superconducting magnet apparatus 102. Moreover, and as described more fully below, the active compensating coil could be disposed on a stand or a table. Alternatively, or in addition to the above-noted configurations, the active compensating coil may be suspended from one of the walls 123-126 or the ceiling 122, or may be suspended from the outer structure of the superconducting magnet apparatus 102. Notably, as described more fully below in connection with Figs. 3-4C, the location, shape, size and current requirements of the active compensating coil are determined using a known finite element analysis techniques and dedicated SW implementations thereof, and/or using commercially available software such as COMSOL MULTIPHYSICS^{®}, CST Studio, INTEGRATED's AMPERES^{™}, or open source implementations like FreeFEM may be used to simulate the target magnetic field and the resultant compensated magnetic field.

Referring again to Fig. 1, active compensating coils 128, 129, 130 and 131 are disposed on one or more of the walls 123, 124, 125 and 126 of the MRI room 120. Moreover, an active compensating coil 132 may be disposed on the ceiling 122. In addition, an active compensating coil 134 could be suspended by a support structure 133 that is connected to a wall, a ceiling or even to the outer portion of the superconducting magnet apparatus 102, and thus away from the superconducting magnet apparatus 102 (e.g., suspended between a wall, ceiling or floor of the MRI room 120 and the outer portion of the superconducting magnet apparatus 102. The locations of the active compensating coils 128-132 and 134 in Fig. 1 is merely for purposes of illustration, and certainly is not an exhaustive. Rather, more or fewer active compensating coils may be disposed on the walls and ceiling of the MRI room 120. As described more fully below, the locations of the active compensating coils 128-132, and 134 may be selected to create a desired shape of the compensated fringe magnetic field in the MRI room 120. Just by way of illustration, for example, active compensating coils can be disposed at the head (upper end of the superconducting magnet apparatus 102) of the patient 10, and at the foot (lower end of the superconducting magnet apparatus 102) of the patient 10. Locating active compensating coils on the walls 124, 126 in this manner will create regions near the head and foot of the patient 10 where the magnitude of the static magnetic field created by the superconducting magnet is reduced to a point where the operation of sensitive electronic equipment can be carried out substantially without electromagnetic interference and/or metal objects can be safely located.

The active compensating coils 128-132 and 134 each may comprise a plurality of coil elements. Moreover, the active compensating coils 128-132 and 134 may be substantially planar. As alluded to above, and as described more fully below, the shapes of the active compensating coils may be determined using known finite element analysis techniques to provide a compensating magnetic field to a simulated target magnetic field with reduce area and/or regions of comparatively low magnetic flux density for operation of certain electronic equipment and presence of metal objects.

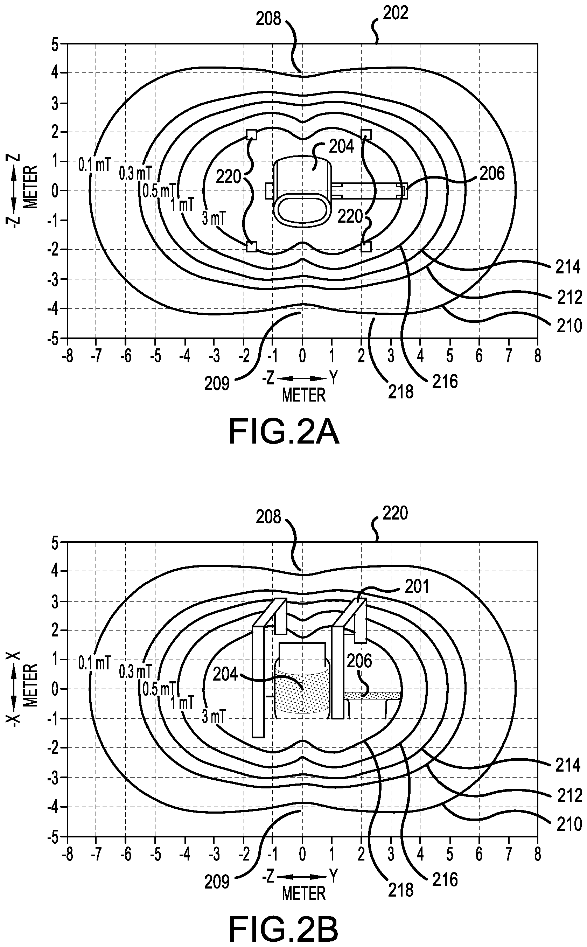

Fig. 2A is top view of a superconducting apparatus and lines of equal magnetic flux density of a raw fringe field distribution before compensation in accordance with a representative embodiment. Various aspects and details of the superconducting apparatus may be common to those described in connection with Fig. 1, and may not be repeated to avoid obscuring the presently described representative embodiments.

A superconducting magnet apparatus 204 is disposed at a location having coordinates 0, 0 in the depicted coordinate system of Fig. 2A. Adjacent to the superconducting magnet apparatus 204 a patient table 206 is disposed and is adapted to be moved within the bore of the superconducting magnet apparatus 204. As may be appreciated, the superconducting magnet apparatus 204 and the patient table 206 may be located in an MRI room, although the boundaries (walls, ceiling, floor) are not depicted. Notably, an outline 201 of an outer structure of the superconducting magnet apparatus 204 provides perspective of the locating of an active compensating coil in a region between the outer structure of the superconducting magnet apparatus and the walls/ceiling of the MRI room in which the superconducting magnet apparatus 204 is disposed as described more fully in connection with representative embodiments in the description of Fig. 1 above.

Lines of constant magnetic flux density 210, 212, 214, 216 and 218 are shown and are located at certain coordinates of the coordinate system of Fig. 2B. As described more fully below, the magnetic flux density of the target magnetic field is simulated, and in the noted example, line 210 has a flux density of 0.1 mT, line 212 has a flux density of 0.3 mT, line 214 has a flux density of 0.5 mT, line 216 has a flux density of 1 mT, and line of constant magnetic flux density 218 line has a flux density of 3 mT. By the present teachings, an active compensating coil is disposed in the MRI room at locations determined by the method of Fig. 3 to "draw in" one or more of the lines of constant magnetic flux density 210, 212, 214, 216 and 218 closer to the superconducting magnet apparatus. This "drawing in" results in a reduction of the radius of one or more of the lines of constant magnetic flux density 210, 212, 214, 216 and 218. As such, and by way of example only, after a current having a determined magnitude flows in the active compensation coil, the line of constant magnetic flux density 214 may have an expanse that is less than approximately +7m. By way of another example, after a current having a determined magnitude flows in the active compensation coil when the distance from the superconducting magnet apparatus is approximately + 4m, the magnetic flux density is approximately 40% less than the raw fringe magnetic field before activation of the active compensating coil. Accordingly, the active compensation coil reduces the expanse of at least one of the lines of constant magnetic flux density 210, 212, 214, 216 and 218, resulting in a greater area within the MRI room is created where electronic equipment susceptible to electromagnetic interference, and/or metal objects may be located.

As shown, at regions 208 and 209, a "dip" in the lines of constant magnetic flux density 210, 212, 214, 216 and 218 exists in the target magnetic field. By locating an active compensation coil at 220 as shown, this dip can be increased. This results in an increase in the areal dimension of regions 208, 209. As a result, the magnitude of the magnetic flux density in regions 208, 209 can be reduced upon flow of current in the active compensation coil, and allow for use of electronic equipment susceptible to electromagnetic interference, and/or metal objects to be located in these increased areas.

Fig. 2B is side view of a superconducting apparatus and lines of equal magnetic flux density of a target field before compensation in accordance with a representative embodiment. Various aspects and details of the superconducting apparatus may be common to those described in connection with Figs. 1 and 2A, and may not be repeated to avoid obscuring the presently described representative embodiments.

A superconducting magnet apparatus 204 is disposed at a location having coordinates 0, 0 in the depicted coordinate system of Fig. 2B. Adjacent to the superconducting magnet apparatus 204 a patient table 206 is disposed and is adapted to be moved within the bore of the superconducting magnet apparatus 204. As may be appreciated, the superconducting magnet apparatus 204 and the patient table 206 may be located in an MRI room, although the boundaries (walls, ceiling, floor) are not depicted.

Lines of constant magnetic flux density 210, 212, 214, 216 and 218 are shown and are located at certain coordinates of the coordinate system of Fig. 2B. As described more fully below, the magnetic flux density of the target magnetic field is simulated, and in the noted example, line 210 has a flux density of 0.1 mT, line 212 has a flux density of 0.3 mT, line 214 has a flux density of 0.5 mT, line 216 has a flux density of 1 mT, and line of constant magnetic flux density 218 line has a flux density of 3 mT. By the present teachings, an active compensating coil is disposed in the MRI room at locations determined by the method of Fig. 3 to "draw in" one or more of the lines of constant magnetic flux density 210, 212, 214, 216 and 218 closer to the superconducting magnet apparatus. This "drawing in" results in a reduction of the radius of one or more of the lines of constant magnetic flux density 210, 212, 214, 216 and 218. As such, and by way of example only, after a current having a determined magnitude flows in the active compensation coil, the line of constant magnetic flux density 214 may have an expanse that is less than approximately + 7m. By way of another example, after a current having a determined magnitude flows in the active compensation coil when the distance from the superconducting magnet apparatus is approximately + 4m, the magnetic flux density is approximately 40% less than the raw fringe magnetic field before activation of the active compensating coil. Accordingly, the active compensation coil reduces the expanse of at least one of the lines of constant magnetic flux density 210, 212, 214, 216 and 218, resulting in a greater area within the MRI room is created where electronic equipment susceptible to electromagnetic interference, and/or metal objects may be located.

As shown, at regions 208 and 209, a "dip" in the lines of constant magnetic flux density 210, 212, 214, 216 and 218 exists in the target magnetic field. By locating an active compensation coil, this dip can be increased. This results in an increase in the areal dimension of regions 208, 209. As a result, the magnitude of the magnetic flux density in regions 208, 209 can be reduced upon flow of current in the active compensation coil, and allow for use of electronic equipment susceptible to electromagnetic interference, and/or metal objects to be located in these increased areas.

Fig. 3 is a flow-chart of a method of determining a shape of a compensation coil and required current density in the compensation coil to provide a specified target shield in a region outside of a main superconducting magnet of an MRI system according to a representative embodiment. Various aspects and details of the method of Fig. 3 are common to those described above in connection with the representative embodiments of Figs. 1-2B. These common aspects and details may not be repeated to avoid obscuring the presently described representative embodiments.

At 301, the method comprises defining a desired spatial distribution of the magnetic raw fringe field. As alluded to above, spatial distribution may be defined using one of a number of known simulation techniques, including but not limited to finite element analysis and/or , and/or using commercially available software such as COMSOL MULTIPHYSICS^{®}. At 301, the raw fringe field in the ambient region is surrounding the superconducting magnet apparatus, such as in the MRI room.

At 302, the method comprises establishing the target compensation field by subtracting the raw magnetic fringe field distribution generated by the superconducting magnet apparatus from the desired (compensated) fringe field. By way of illustration, the desired fringe field would be determined by subtracting the compensating magnetic flux density from the lines of constant magnetic flux density 210, 212, 214, 216 and 218 of Figs. 2A-2B to provide the desired magnetic fringe field. Again, this can be done using finite element analysis and/or dedicated SW implementations thereof, and/or using commercially available software such as COMSOL MULTIPHYSICS^{®}, CST Studio, INTEGRATED's AMPERES^{™}, or open source implementations like FreeFEM.

At 303, the method comprises using the target compensation field to define the shape of the active compensation coil and the required current density in the active compensation coil through iterative simulation (e.g., using COMSOL MULTIPHYSICS^{®} CST Studio, INTEGRATED's AMPERES^{™}, or open source implementations like FreeFEM). Just by way of illustration, the calculation of the required shape and current density for assemblies to reduce the field outside such assemblies may be carried out using known methods known for calculating a low-field pocket inside a raw fringe magnetic field compensating structure such as described in "Magnetic Decoupling of the Linac in a Low Field Biplanar Linac-MR System" by J. St. Aubin, et al. (Med. Phy 39 (9), September 2010, pp. 4755-4761) and/or in "Magnetic Shielding Investigation for a 6 MV In-Line Linac within the Parallel Configuration of a Linac-MR system" by D.M. Santos, et al. (Med. Phy 39 (2), February 2012, pp. 788-797). The entire disclosures of "Magnetic Decoupling of the Linac in a Low Field Biplanar Linac-MR System" and "Magnetic Shielding Investigation for a 6 MV In-Line Linac within the Parallel Configuration of a Linac-MR system" are specifically incorporated herein by reference.

Using known software, the inventor has determined that generally the shape of the coils may be substantially circular or elliptical, but this is not necessarily the case in all applications to provide the compensating magnetic field. Moreover, the coils may be substantially planar.

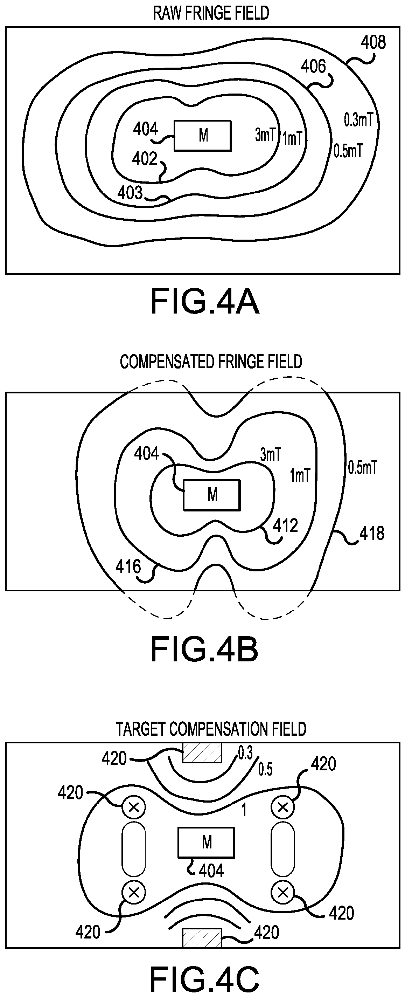

Fig. 4A is top view of a superconducting apparatus and lines of equal magnetic flux density of a raw fringe magnetic field before compensation in accordance with a representative embodiment. Various aspects and details of the method of Fig. 4A are common to those described above in connection with the representative embodiments of Figs. 1-3. These common aspects and details may not be repeated to avoid obscuring the presently described representative embodiments.

As shown, the raw fringe field has lines of constant magnet flux density in a region around a superconducting magnet apparatus 404. Specifically, line 402 shows a 3T magnetic field density, line 403 shows a 1T magnetic field density, line 406 shows a 0.5T magnetic field density, and line 408 shows a 0.1T magnetic field density. Specifically, Fig. 4A shows a defined desired spatial distribution of the magnetic raw fringe field. As alluded to above, the spatial distribution of the lines of equal magnetic flux density may be defined using one of a number of known simulation techniques, including but not limited to finite element analysis and/or using commercially available software such as COMSOL MULTIPHYSICS^{®}. In Fig. 4A, the raw fringe field in the ambient region is surrounding the superconducting magnet apparatus 404, such as in the MRI room.

Fig. 4B is top view of a superconducting apparatus and lines of equal magnetic flux density of a compensated fringe field using a raw fringe magnetic field compensating structure comprising an active compensating coil in accordance with a representative embodiment. Various aspects and details of the method of Fig. 4A are common to those described above in connection with the representative embodiments of Figs. 1-3. These common aspects and details may not be repeated to avoid obscuring the presently described representative embodiments.

Specifically, line 412 shows a 3T magnetic field density, line 416 shows a 1T magnetic field density, and line 418 shows a 0.1T magnetic field density. Notably, the magnetic field density of Fig. 4B corresponds to 303 of Fig. 3. As noted above, in the depicted embodiment, active compensating coils 420 are located based on calculations noted above and below.

Fig. 4C is top view of a superconducting apparatus and lines of equal magnetic flux density of a target compensation field after compensation generated by a raw fringe magnetic field compensating structure comprising an active compensating coil in accordance with a representative embodiment. Various aspects and details of the method of Fig. 4A are common to those described above in connection with the representative embodiments of Figs. 1-3. These common aspects and details may not be repeated to avoid obscuring the presently described representative embodiments.

The target compensation field of Fig. 4C is determined by subtracting compensated fringe field of Fig. 4B from the raw fringe field of Fig. 4A (as described above in connection with 302). Again, this can be done using finite element analysis and/or dedicated SW implementations thereof, and/or using commercially available software such as COMSOL MULTIPHYSICS^{®}, CST Studio, INTEGRATED's AMPERES^{™}, or open source implementations like FreeFEM.

The determination of the target compensation field of Fig. 4C results in determination of the location of and electrical current in the active compensation coils 420 as shown. As noted above, these positions and currents are determined using the noted available software, which uses the location and current of the active compensation coils to calculate the realized target compensation field of Fig. 4C from generalized versions of Biot-Savart's law, in order to provide the desired lines of equal magnetic flux density of the compensated magnetic field.

Referring again to Fig. 4B, a comparison of the locations of the lines of equal magnetic field density in Fig. 4B to the lines of equal magnetic field density in Fig. 4C, shows the compensated magnetic field is brought "closer" to the superconducting magnet apparatus 404, and provides a greater area in which the magnitude of the lines of equal magnetic field density are reduced thereby providing more space for locating equipment sensitive to the magnetic field generated by the superconducting magnet apparatus 404 where the magnitude of the magnetic field density is comparatively low. Moreover, a because the locations of the lines of equal magnetic field density in Fig. 4B are closer to the superconducting magnet apparatus 404, thereby reducing the overall area needed to contain the superconducting magnet apparatus 404. This results, of course, in a reduction of the area of the MRI room where the superconducting magnet apparatus 404 is disposed.

One or more embodiments of the disclosure may be referred to herein, individually and/or collectively, by the term "invention" merely for convenience and without intending to voluntarily limit the scope of this application to any particular invention or inventive concept. Moreover, although specific embodiments have been illustrated and described herein, it should be appreciated that any subsequent arrangement designed to achieve the same or similar purpose may be substituted for the specific embodiments shown. This disclosure is intended to cover any and all subsequent adaptations or variations of various embodiments. Combinations of the above embodiments, and other embodiments not specifically described herein, will be apparent to those of skill in the art upon reviewing the description.

The Abstract of the Disclosure is provided to comply with 37 C.F.R. §1.72(b) and is submitted with the understanding that it will not be used to interpret or limit the scope or meaning of the claims. In addition, in the foregoing Detailed Description, various features may be grouped together or described in a single embodiment for the purpose of streamlining the disclosure. This disclosure is not to be interpreted as reflecting an intention that the claimed embodiments require more features than are expressly recited in each claim. Rather, as the following claims reflect, inventive subject matter may be directed to less than all of the features of any of the disclosed embodiments. Thus, the following claims are incorporated into the Detailed Description, with each claim standing on its own as defining separately claimed subject matter.

The preceding description of the disclosed embodiments is provided to enable any person skilled in the art to practice the concepts described in the present disclosure. As such, the above disclosed subject matter is to be considered illustrative, and not restrictive, and the appended claims are intended to cover all such modifications, enhancements, and other embodiments which fall within the true spirit and scope of the present disclosure. Thus, to the maximum extent allowed by law, the scope of the present disclosure is to be determined by the broadest permissible interpretation of the following claims and their equivalents and shall not be restricted or limited by the foregoing detailed description.

## Claims

1. In a magnetic resonance imaging (MRI) room, a raw fringe magnetic field compensating structure, comprising:
an active compensating coil adapted to reduce a target magnetic flux density outside a magnet apparatus of an MR in a defined area, wherein the active compensating coil is not disposed in the magnet apparatus.

2. The raw fringe magnetic field compensating structure of claim 1, wherein the active compensating coil is a component of the MRI room and not a component of the magnet apparatus.

3. The raw fringe magnetic field compensating structure of any of claims 1-2, wherein the active compensating coil further comprises a passive magnetic component.

4. The raw fringe magnetic field compensating structure of any of claims 1-3, wherein the MRI room is a mobile room.

5. The raw fringe magnetic field compensating structure of any of claims 1-4, wherein the MRI room comprises a wall, and the active compensating coil is disposed in the wall.

6. The raw fringe magnetic field compensating structure of any of claims 1-5, wherein the active compensating coil is substantially circular.

7. The raw fringe magnetic field compensating structure of any of claims 1-6, wherein the active compensating coil comprises a plurality of coil elements.

8. The raw fringe magnetic field compensating structure of claim 7, wherein the plurality of coil elements comprises coils having an elliptical shape.

9. The raw fringe magnetic field compensating structure of any of claims 1-8, wherein the active compensating coil is disposed at a location in the MRI room between a superconducting magnet apparatus and a wall or ceiling of the MRI room.

10. The raw fringe magnetic field compensating structure of claim 9, wherein the active compensating coil is a first active compensating coil in the wall and the structure further comprises a second active compensating coil disposed between a superconducting magnet apparatus and a wall or ceiling of the MRI room.

11. The raw fringe magnetic field compensating structure of any of claims 1-10, wherein the magnet apparatus generates the target magnetic flux density comprising lines of constant magnetic flux density at distances from the magnet apparatus, and active compensating coil reduce the distance from the magnet apparatus of at least one of the lines of constant magnetic flux density.

12. The fringe magnetic field compensating structure of claim 11, wherein when the distance from the magnet apparatus is approximately + 4m, and a magnetic flux density is approximately 40% less than a raw fringe magnetic field before activation of the active compensating coil.

13. The raw fringe magnetic field compensating structure of any of claims 1-12, wherein the active compensating coil comprises a static magnetic field (SMF) coil.

14. The raw fringe magnetic field compensating structure of any of claims 1-13, wherein the active compensating coil comprises an ultra-low frequency (ULF) coil.

15. A method of compensating for a raw fringe magnetic field in an MRI room, the method comprising:
providing an active compensating coil adapted to reduce a target magnetic flux density outside a magnet apparatus of an MR in a defined area, wherein the active compensating coils are not disposed in or on the magnet apparatus.
